# FASCICULE DE BREVET EUROPEEN

(11) **EP 2 625 940 B1**
(45) Date de publication et mention de la délivrance du brevet: **06.03.2019**
(21) Numéro de dépôt: 11770082.3
(22) Date de dépôt: 06.10.2011
(51) Int. Cl.: H05K 7/20

(54) **MODULE ELECTRIQUE, GLISSIERE D'UN TEL MODULE ET CARTE ELECTRONIQUE DESTINEE A ETRE LOGEE DANS UN TEL MODULE**
ELEKTRONISCHES MODUL, FÜHRUNGSSCHIENE EINES DERARTIGEN MODULS UND LEITERPLATTE FÜR DEN EINSATZ IN EIN DERARTIGES MODUL
ELECTRONIC MODULE, GUIDE RAIL OF SUCH A MODULE AND CIRCUIT BOARD INTENDED TO BE SLOTTED INTO SUCH A MODULE

(30) Priorité: 08.10.2010 FR 1058208
(43) Date de publication de la demande: 14.08.2013
(73) Titulaire: Safran Electronics & Defense, 92100 Boulogne-Billancourt (FR)
(72) Inventeur: MERLET, Etienne, F-92100 Boulogne-Billancourt (FR); COURTEILLE, Jean-Marie, F-92100 Boulogne-Billancourt (FR); BESOLD, Jean-Eric, décédé (FR)
(74) Mandataire: Lavialle, Bruno François Stéphane
(86) Numéro de dépôt international: PCT/EP2011/067460
(87) Numéro de publication internationale: WO 2012/045811

(56) Documents cités:
- EP-A1- 0 470 926
- EP-A2- 1 011 300
- GB-A- 2 145 290
- US-A- 3 771 023
- US-A- 4 549 602
- US-A1- 2004 201 967
- US-A1- 2010 118 489

## Description

L'invention concerne un module électronique et plus exactement un de ceux comprenant un boîtier comportant au moins une paire de glissières pour définir un logement pour une carte électronique.

L'invention concerne également une glissière d'un tel module ainsi qu'une carte électronique destinée à être logée dans un tel module.

### ARRIERE PLAN TECHNOLOGIQUE DE L'INVENTION

Un module électronique, tel que ceux utilisés dans les avions pour assurer le fonctionnement de ceux-ci en fournissant par exemple des ressources de calculs, comprend un boîtier comportant des logements recevant chacun une carte électronique. Le boîtier est usuellement pourvu de grilles d'aération agencées pour créer une circulation d'un flux d'air global entre deux faces opposées du boîtier de telle manière qu'une part identique du flux d'air traverse chacun des logements pour refroidir la carte électronique reçue dans ledit logement.

Il est connu de définir le flux d'air global chargé de refroidir les cartes électroniques contenues dans le module par exemple en adaptant la taille des grilles d'aération.

Or, toutes les cartes électroniques ne produisent pas la même quantité de chaleur de sorte que le refroidissement créé par répartition homogène du flux d'air global entre les logements n'est pas nécessairement adapté à la carte électronique.

En outre, dans certaines applications du domaine aéronautique, les modules électroniques sont regroupés dans des baies et se partagent les moyens de ventilation de la baie. Des normes fixent de nombreuses caractéristiques du module électronique et en particulier le débit d'air, et la perte de charge associée à l'aération du module électronique ainsi que le positionnement des entrées et des sorties d'air ... imposant un débit d'air et une température maximale de l'air à la sortie du module pour assurer que chaque module pourra bénéficier d'un flux d'air apte à refroidir ses composants.

Il est également connu un module électronique comportant un dispositif de réglage du flux d'air global qui est disposé en regard de l'une des grilles d'aération.

Encore une fois, le module électronique modifié se retrouve donc caractérisé dans son ensemble par une certaine capacité de refroidissement globale qui ne convient pas nécessairement à toutes les cartes électroniques. En outre, une fois les cartes en place dans le module électronique, le dispositif de réglage est difficilement accessible, ce qui rend le réglage du flux d'air global peu aisé. De plus, la plage de variation du flux d'air global s'avère limitée.

Le document EP 0 470 926 décrit une structure pouvant accueillir des cartes à circuits imprimés, des volets étant montés pivotants dans un fond de la structure.

### OBJET DE L'INVENTION

Un but de l'invention est de proposer un module électronique obviant aux problèmes précités.

### BREVE DESCRIPTION DE L'INVENTION

En vue de la réalisation de ce but, on propose un module électronique comprenant un boîtier comportant au moins une paire de glissières pour définir un logement recevant une carte électronique, les glissières étant fixées sur deux faces opposées du boîtier qui sont pourvues de moyens d'aération agencés pour créer une circulation d'un flux d'air global entre les deux faces.

Selon l'invention, le module électronique comporte au moins un écran agencé dans le logement entre l'une des glissières et la carte électronique associée pour définir un passage d'un flux d'air individuel dans le logement, le module comportant, au niveau du logement, un détrompeur destiné à empêcher l'insertion dans le logement d'une carte électronique non adaptée au flux d'air individuel pouvant traverser le logement.

En définissant directement un flux d'air individuel de chaque logement et non plus le flux d'air global de l'ensemble du module, il est possible d'adapter le refroidissement à chaque carte électronique sans pour autant influer sur le flux d'air global circulant dans le module électronique. La définition du flux d'air individuel dans le logement est directement dépendante de la carte électronique que l'on s'apprête à introduire dans ledit logement de sorte que le refroidissement dans le logement soit en adéquation avec le refroidissement nécessaire de la carte électronique.

Selon un mode de réalisation privilégié, au moins deux logements sont délimités dans le boîtier et l'écran est agencé pour répartir sélectivement le flux d'air global entre les deux logements.

Ainsi, l'écran permet de répartir le flux d'air global de façon aisée entre les différents logements, selon les cartes électroniques que l'on s'apprête à introduire dans chaque logement, ce que ne permettaient pas les dispositifs de l'art antérieur définissant seulement le flux d'air global. La répartition du flux d'air global est directement dépendante des cartes électroniques destinées à être introduites dans les logements selon le refroidissement nécessaire des cartes électronique. En cas de permutation de carte électronique, il suffira également de changer d'écran ou la position de l'écran pour répartir de nouveau le flux d'air global entre les logements, la répartition se faisant toujours de la façon la plus optimale qu'il soit quant au refroidissement nécessaire de chaque carte électronique.

De façon privilégiée, l'écran est également agencé entre la glissière et la carte électronique de sorte à répartir sélectivement le flux d'air individuel associé entre différentes zones du logement.

En fonction de la position de l'écran, il est ainsi possible de rediriger le flux d'air individuel vers des zones particulières de la carte électronique par exemple lorsque la carte comporte une zone regroupant des composants à fort échauffement relativement aux autres composants de la carte.

L'invention a également pour objet une glissière d'un tel module ainsi qu'une carte électronique destinée à être logée dans un tel module.

### BREVE DESCRIPTION DES DESSINS

L'invention sera mieux comprise à la lumière de la description qui suit d'un mode de réalisation particulier non limitatif de l'invention.

Il sera fait référence aux dessins annexés, parmi lesquels :
- la figure 1 est une vue en perspective d'un module électronique selon l'invention ;
- la figure 2 est une vue partielle des logements du module électronique illustré à la figure 1 ;
- la figure 3 est une vue en perspective d'une carte électronique destinée à être logée dans un des logements illustrés à la figure 2.

### DESCRIPTION DETAILLEE DE L'INVENTION

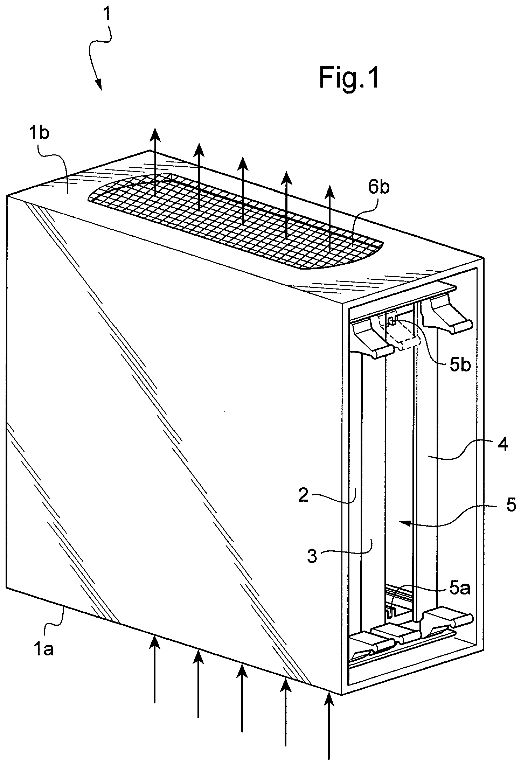

En référence à la figure 1, le module électronique comprend un boîtier 1 comprenant ici quatre paires de glissières pour définir quatre logements. Dans l'exemple illustré, trois cartes électroniques 2, 3, 4 sont reçues dans trois des quatre logements et un dernier logement 5 est vide. Chaque logement est défini par une paire de glissières agencées pour recevoir entre elles une carte électronique engagée par coulissement entre les glissières. Le dernier logement 5 est ainsi défini par une glissière inférieure 5a et une glissière supérieure 5b fixées respectivement sur la face inférieure la du boîtier 1 et la face supérieure 1b du boîtier 1, selon l'orientation de la figure 1.

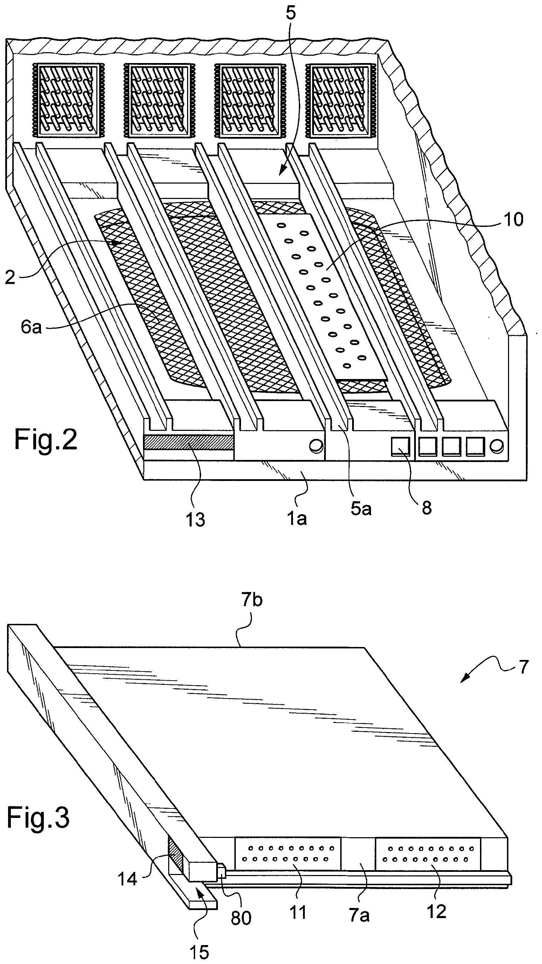

Le boîtier 1 comporte des moyens d'aération agencés pour créer une circulation d'un flux d'air global entre sa face inférieure la et sa face supérieure 1b comme indiqué par les flèches noires. Ici, les moyens d'aération comprennent une grille inférieure 6a (que l'on verra mieux à la figure 2) dont est pourvue la face inférieure la du boîtier 1 et une grille supérieure 6b dont est pourvue la face supérieure 1b du boîtier 1.

En référence à la figure 3, une carte électronique 7 est destinée à être introduite dans le dernier logement vide 5. La carte électronique 7 est conformée pour pouvoir être guidée par les glissières inférieure et supérieure 5a, 5b lors de sa réception dans le logement vide 5 et être maintenue en place dans ledit logement par ces mêmes glissières. La carte électronique 7 est poussée au fond du logement jusqu'à ce que des connecteurs de la carte 7 se connectent à des connecteurs complémentaires du module électronique, les connecteurs complémentaires étant disposés dans le boîtier 1 au fond du logement vide 5 (que l'on verra mieux à la figure 2). De façon connue en elle-même, les glissières et/ou le boîtier comportent des moyens de verrouillage s'opposant au retrait accidentel de la carte hors de son logement. Ces moyens comprennent par exemple un verrou escamotable entre une position en saillie dans la glissière et une position de dégagement de la glissière.

Le module électronique comporte au moins un écran agencé dans chaque logement.

Un écran est ainsi agencé dans le dernier logement 5 entre l'une des glissières supérieure 5b ou inférieure 5a et la carte électronique associée 7 lorsque ladite carte est en place dans le dernier logement 5. L'écran définit un passage dans ledit logement 5 d'un flux d'air individuel issu du flux d'air global, le flux d'air individuel étant destiné à refroidir la carte électronique 7.

Un premier écran 10 est solidaire de la glissière inférieure 5a. L'écran 10 obstrue en partie la grille inférieure 6a du boîtier 1 ce qui lui permet de réguler le flux d'air individuel dans le logement 5. L'écran 10 est par exemple une feuille métallique et la glissière inférieure 5a est conformée pour porter ledit écran. L'écran 10 est ici en une seule pièce avec la glissière inférieure 5a.

La glissière inférieure 5a est alors caractérisée par le premier écran 10 qui contribue lui-même à définir la section de passage du flux d'air individuel traversant le dernier logement 5. La glissière inférieure 5a comporte un indicateur de cette caractérisation. Il est ainsi possible de repérer rapidement si le refroidissement défini par l'écran 10 dans le dernier logement 5 est en adéquation avec le refroidissement nécessaire de la carte électronique que l'on s'apprête à introduire dans ledit logement. La glissière inférieure 5a comporte un détrompeur comme indicateur. Ce détrompeur est par exemple constitué d'une cavité 8 ménagée sur une face frontale de la glissière et ayant des dimensions adaptées pour coopérer avec un pion 80 monté en correspondance sur la carte. Le positionnement et les dimensions des pions des cartes et le positionnement et les dimensions des cavités des glissières sont définis pour correspondre à un niveau de refroidissement nécessaire pour chaque carte et à un niveau de refroidissement procuré par chaque glissière. Le détrompeur s'oppose ainsi à la mise en place correcte d'une carte nécessitant un niveau de refroidissement différent du niveau de refroidissement procuré par la glissière.

La carte électronique 7 est également pourvue d'un écran 11 solidaire d'un côté inférieur 7a de la carte électronique 7, ledit côté étant destiné à venir en regard de la grille inférieure 6a lorsque la carte électronique 7 est en place dans le logement. L'écran 11 est par exemple une feuille métallique venant obstruer en partie la grille inférieure 6a du boîtier 1 et ainsi réguler le flux d'air individuel dans le logement 5.

L'écran 11 permet de simplifier encore davantage un ajustement du flux d'air dans le logement 5 puisque la carte électronique 7 porte elle-même le deuxième écran 11.

La carte électronique 7 est en outre pourvue d'un écran 12. L'écran 12 est un élément monté sur le côté inférieur 7a de la carte électronique 7. Le troisième écran 12 est par exemple un élément plastique assimilable à un composant passif de la carte électronique 7. L'écran 12 comprend ici une partie plane qui forme l'écran lui-même et qui est solidaire de deux pattes métalliques de telle manière que l'écran 12 puisse être fixé comme un composant classique sur la carte électronique 7, c'est-à-dire par brasage.

Ainsi, le module électronique peut comporter un ou plusieurs types d'écran, différents ou identiques, pour définir le passage du flux d'air individuel dans les logements. Il est ainsi possible selon la forme et le nombre d'écrans employés, d'adapter le passage du flux d'air individuel (son débit, sa perte de charge ...) à la puissance de toute carte électronique pouvant être introduite dans ledit logement pour que le refroidissement défini par le ou les écrans dans le logement concerné soit en adéquation avec le refroidissement nécessaire de la carte électronique.

On notera que les écrans peuvent être agencés pour adapter le flux d'air à une partie seulement des logements mais aussi, plus généralement, pour répartir sélectivement le flux d'air global entre tous les logements du module électronique. En effet, en disposant les écrans dans un des logements, on augmente les flux d'air individuels des autres logements. Il est donc possible de refroidir de façon privilégiée certains logements. Les écrans peuvent également être agencés dans l'un des logements de sorte à répartir sélectivement le flux d'air individuel associé entre les différentes zones du logement. Ainsi certaines zones de la carte électronique elle-même peuvent être plus refroidies que les autres.

Bien entendu, l'invention n'est pas limitée au mode de réalisation préféré illustré et est susceptible de variantes de réalisation qui apparaîtront à l'homme de métier sans sortir du cadre de l'invention tel que défini par les revendications.

En particulier, bien qu'ici les écrans n'aient été représentés que dans un seul logement du module électronique, il va de soi qu'on peut avoir des écrans agencés dans tout ou partie des logements du module électronique.

Bien qu'ici des écrans soient solidaires d'un côté inférieur 7a de la carte électronique 7 et de la glissière inférieure 5a, on pourra bien entendu avoir des écrans disposés autrement dans le module électronique. Par exemple, le module pourra comporter des écrans solidaires de la glissière supérieure 5b ou d'un côté supérieur 7b de la carte électronique 7 opposé au côté inférieur 7a de la carte électronique 7. Le module pourra également comporter seulement des écrans solidaires des glissières ou seulement des écrans solidaires de la carte électronique 7. En outre, le module pourra comporter n'importe quel nombre d'écrans voir un unique écran. Les écrans pourront également prendre une forme différente de celles illustrées.

Bien qu'ici on ait décrit les écrans comme des plaques métalliques ou des composants plastiques, on pourra envisager d'autres types d'écrans permettant de définir le flux individuel traversant le logement concerné. Par exemple, on pourra imaginer que les écrans soient perforés de façon adéquate. Les écrans pourront également être des grilles très ajourées et conformées pour recevoir des bouchons d'obstruction.

Bien qu'ici le premier écran 10 soit d'une seule pièce avec la glissière inférieure 5a, le premier écran 10 pourra être seulement solidaire de la glissière inférieure 5a. On pourra ainsi imaginer que le module électronique comporte un écran solidaire d'une des glissières par exemple par clipsage de l'écran à la glissière lorsque la glissière est en place dans le module électronique, la carte électronique ne coopérant pas encore avec ladite glissière. On pourra également visser un écran à la glissière lorsque la glissière est en place dans le module électronique, la carte électronique ne coopérant pas encore avec ladite glissière.

Bien qu'ici l'indicateur soit porté par la glissière inférieure 5a, l'indicateur pourra être porté par la glissière supérieure 5b.

D'autres indicateurs pourront être employés. On pourra par exemple avoir un indicateur sous forme de barrette colorée 13, un code couleur ayant été préalablement déterminé pour associer une couleur à une caractéristique du flux individuel comme son débit. On pourra également envisager qu'une des glissières elle-même forme l'indicateur. Par exemple, la glissière pourra être colorée, un code couleur ayant été préalablement déterminé pour associer une couleur à une caractéristique du flux individuel traversant le logement comme son débit.

De façon privilégiée, le module comportera au moins un détrompeur au niveau de chaque logement pour éviter une erreur d'adéquation entre un logement et une carte électronique insérée dans ledit logement. Un indicateur supplémentaire pourra en outre être agencé au niveau de l'un ou l'autre des logements.

En outre, la carte électronique 7 pourra également comporter un indicateur caractérisant le flux d'air individuel devant traverser le logement associé à la carte 7 pour le refroidissement de ladite carte. Par exemple, la carte électronique 7 pourra comporter une barrette colorée 14, un code couleur ayant été préalablement déterminé pour associer une couleur à une caractéristique du flux d'air nécessaire au refroidissement de la carte électronique 7 comme son débit.

De préférence, pour faciliter la vérification de l'adéquation au niveau refroidissement entre une carte électronique 7 et le logement dans lequel ladite carte doit être introduite, l'indicateur de la carte électronique 7 et celui de la glissière seront tous deux colorés, les deux codes couleur des indicateurs étant liés. L'indicateur de la glissière pourra être une barrette colorée ou la glissière elle-même colorée. Par exemple, si l'indicateur de la carte électronique 7 et de la glissière sont de même couleur, cela signifie que le logement dans lequel est fixée la glissière est en adéquation avec la carte électronique 7 au niveau du refroidissement de ladite carte.

De plus, on pourra conformer la carte électronique 7 pour qu'une fois celle-ci en place dans un des logements, au moins une partie de la barrette colorée 14 de la carte électronique et au moins une partie de l'indicateur colorée de la glissière soient visibles de l'extérieur du logement. En référence à la figure 3, la carte électronique comporte ici un orifice 15 de sorte que si la carte électronique 7 est introduite dans le logement 2, elle laisse toujours entrevoir une partie de la barrette colorée 13. Ainsi, même si la carte est en place dans le logement, une possible erreur d'adéquation sera facilement détectable, par exemple les couleurs de l'indicateur de la glissière et de la carte électronique ne correspondant pas.

Bien qu'il ait été écrit qu'un indicateur ou un détrompeur caractérise le flux d'air individuel pouvant ou devant traverser le logement associé, un indicateur ou un détrompeur pourra être employé pour caractériser d'autres paramètres du logement associé.

Par exemple, il est connu qu'une carte électronique de puissance nécessite un refroidissement plus important qu'une carte électronique de commande. Un détrompeur pourra ainsi être agencé au niveau d'un ou de plusieurs logements, traversés chacun par un flux d'air individuel destiné à refroidir une carte électronique de commande, pour empêcher qu'une carte électronique de puissance puisse être insérée dans l'un ou l'autre des logements. Le détrompeur permet ainsi de caractériser la fonction des différents logements du module. En variante, si l'indicateur est sous forme de barrette colorée, une couleur indiquera qu'un logement est destiné à ne recevoir qu'une carte électronique de puissance et une couleur indiquera qu'un logement est destiné à ne recevoir qu'une carte électronique de commande.

On peut en outre prévoir pour un ou plusieurs logements plusieurs types de détrompeur. Par exemple lorsqu'un module reçoit plusieurs cartes de puissance ayant des puissances différentes et une ou plusieurs cartes de commande, chaque logement peut comprendre un détrompeur commande/puissance et, en ce qui concerne les logements destinées aux cartes de puissance, un détrompeur selon la puissance de la carte destinée à être reçue dans ledit logement.

## Revendications

1. Module électronique comprenant un boîtier (1) comportant au moins une paire de glissières (5a, 5b) pour définir un logement (5) recevant une carte électronique (7), les glissières étant fixées sur deux faces (1a, 1b) opposées du boîtier qui sont pourvues de moyens d'aération (6a, 6b) agencés pour créer une circulation d'un flux d'air global entre les deux faces, le module électronique étant **caractérisé en ce qu'**il comporte au moins un écran (10, 11, 12) agencé dans le logement entre l'une des glissières et la carte électronique associée pour définir un passage d'un flux d'air individuel dans le logement, le module comportant, au niveau du logement, un détrompeur destiné à empêcher l'insertion dans le logement d'une carte électronique non adaptée au flux d'air individuel pouvant traverser le logement (5).

2. Module selon la revendication 1, dans lequel au moins deux logements (5) sont délimités dans le boîtier (1) et l'écran (10, 11, 12) est agencé pour répartir sélectivement le flux d'air global entre les deux logements.

3. Module selon la revendication 1, dans lequel l'écran (10, 11, 12) est également agencé entre la glissière (5a, 5b) et la carte électronique (7) de sorte à répartir sélectivement le flux d'air individuel associé entre différentes zones du logement (5).

4. Module selon la revendication 1, dans lequel l'écran (11, 12) est solidaire de la carte électronique (7) en place dans le logement (5).

5. Module selon la revendication 4, dans lequel l'écran (11, 12) est un élément monté sur la carte électronique (7) en place dans le logement (5).

6. Module selon la revendication 1, dans lequel l'écran (10) est solidaire de la glissière (5a, 5b).

7. Module selon la revendication 6, dans lequel l'écran (10) est d'une seule pièce avec la glissière (5a, 5b) .

8. Module selon la revendication 1, dans lequel la glissière (5a, 5b) comporte un indicateur caractérisant le flux d'air individuel pouvant traverser le logement (5) associé.

9. Module selon la revendication 8, dans lequel l'indicateur est une barrette colorée (13).

10. Module selon la revendication 8, dans lequel la glissière (5a, 5b) est elle-même colorée pour former l'indicateur.

11. Carte électronique d'un module selon la revendication 1, comportant un indicateur caractérisant le flux d'air individuel devant traverser le logement associé à la carte pour le refroidissement de ladite carte.

12. Carte électronique selon la revendication 11, dans lequel l'indicateur est une barrette colorée (14), la glissière comportant un indicateur coloré qui caractérise le flux d'air individuel pouvant traverser le logement associé, la carte électronique étant conformée pour qu'une fois en place dans le logement, au moins une partie de la barrette colorée et au moins une partie de l'indicateur coloré de la glissière soient visibles de l'extérieur du logement.

13. Carte électronique d'un module selon la revendication 5, dont au moins une face est conformée pour recevoir un écran (11, 12).

14. Glissière d'un module selon l'une quelconque des revendications 1 à 4 et 6 à 10, conformée pour recevoir un écran.

## Patentansprüche

1. Elektronisches Modul, umfassend ein Gehäuse (1), das mindestens ein Paar Führungsschienen (5a, 5b) umfasst, um eine Aufnahme (5) zu definieren, die eine Leiterplatte (7) aufnimmt, wobei die Führungsschienen an zwei gegenüberliegenden Flächen (1a, 1b) des Gehäuses befestigt sind, die mit Belüftungsmitteln (6a, 6b) versehen sind, welche so ausgebildet sind, dass sie eine Zirkulation eines Gesamtluftstroms zwischen den beiden Flächen erzeugen, wobei das elektronische Modul **dadurch gekennzeichnet ist, dass** es mindestens eine Abschirmung (10, 11, 12) umfasst, die in der Aufnahme zwischen einer der Führungsschienen und der dazugehörigen Leiterplatte angeordnet ist, um einen Durchlass für einen individuellen Luftstrom in der Aufnahme zu definieren, wobei das Modul im Bereich der Aufnahme eine Verwechslungssicherung umfasst, die dazu bestimmt ist, das Einfügen einer Leiterplatte, die nicht an den individuellen Luftstrom angepasst ist, der die Aufnahme (5) durchströmen kann, in die Aufnahme zu verhindern.

2. Modul nach Anspruch 1, bei dem mindestens zwei Aufnahmen (5) in dem Gehäuse (1) begrenzt sind, und die Abschirmung (10, 11, 12) so ausgebildet ist, dass sie den Gesamtluftstrom selektiv unter den beiden Aufnahmen aufteilt.

3. Modul nach Anspruch 1, bei dem die Abschirmung (10, 11, 12) ferner zwischen der Führungsschiene (5a, 5b) und der Leiterplatte (7) so ausgebildet ist, dass sie den dazugehörigen individuellen Luftstrom selektiv unter verschiedenen Zonen der Aufnahme (5) aufteilt.

4. Modul nach Anspruch 1, bei dem die Abschirmung (11, 12) fest mit der in der Aufnahme (5) vorhandenen Leiterplatte (7) verbunden ist.

5. Modul nach Anspruch 4, bei dem die Abschirmung (11, 12) ein Element ist, das auf der in der Aufnahme (5) vorhandenen Leiterplatte (7) montiert ist.

6. Modul nach Anspruch 1, bei der die Abschirmung (10) fest mit der Führungsschiene (5a, 5b) verbunden ist.

7. Modul nach Anspruch 6, bei dem die Abschirmung (10) einstückig mit der Führungsschiene (5a, 5b) ist.

8. Modul nach Anspruch 1, bei dem die Führungsschiene (5a, 5b) einen Indikator umfasst, der den individuellen Lluftstrom, der die dazugehörige Aufnahme (5) durchströmen kann, charakterisiert.

9. Modul nach Anspruch 8, bei dem der Indikator ein Farbstreifen (13) ist.

10. Modul nach Anspruch 8, bei dem die Führungsschiene (5a, 5b) selbst gefärbt ist, um den Indikator zu bilden.

11. Leiterplatte für ein Modul nach Anspruch 1, umfassend einen Indikator, der den individuellen Luftstrom charakterisiert, der die zur Leiterplatte gehörige Aufnahme zur Kühlung der genannten Leiterplatte durchströmen muss.

12. Leiterplatte nach Anspruch 11, bei der der Indikator ein Farbstreifen (14) ist, wobei die Führungsschiene einen Farbindikator umfasst, der den individuellen Luftstrom, der die dazugehörige Aufnahme durchströmen kann, charakterisiert, wobei die Leiterplatte so geformt ist, dass, sobald sie sich in der Aufnahme befindet, mindestens ein Teil des Farbstreifens und mindestens ein Teil des Farbindikators der Führungsschiene von außerhalb der Aufnahme sichtbar sind.

13. Leiterplatte für ein Modul nach Anspruch 5, von der mindestens eine Fläche so geformt ist, dass sie eine Abschirmung (11, 12) aufnimmt.

14. Führungsschiene für ein Modul nach einem der Ansprüche 1 bis 4 und 6 bis 10, die so geformt ist, dass sie eine Abschirmung aufnimmt.

## Claims

1. An electronics module comprising a box (1) including at least one pair of slideways (5a, 5b) to define a housing (5) for receiving an electronics card (7), the slideways being fastened to two opposite faces (1a, 1b) of the box that are provided with ventilation means (6a, 6b) arranged to establish a flow of a total stream of air between the two faces, the electronics module being **characterized in that** it includes at least one screen (10, 11, 12) arranged in the housing between one of the slideways and the associated electronics card in order to define a passage for an individual stream of air in the housing, the module including keying means associated with the housing to prevent an electronics card being inserted into the housing if the electronics card is not matched to the individual stream of air that can pass through the housing (5).

2. A module according to claim 1, wherein at least two housings (5) are defined in the box (1) and the screen (10, 11, 12) is arranged to share the total stream of air selectively between the two housings.

3. A module according to claim 1, wherein the screen (10, 11, 12) is also arranged between the slideway (5a, 5b) and the electronics card (7) in such a manner as to distribute the associated individual stream of air selectively between different zones of the housing (5).

4. A module according to claim 1, wherein the screen (11, 12) is secured to the electronics card (7) in place in the housing (5).

5. A module according to claim 4, wherein the screen (11, 12) is an element mounted on the electronics card (7) in place in the housing (5).

6. A module according to claim 1, wherein the screen (10) is secured to the slideway (5a, 5b).

7. A module according to claim 6, wherein the screen (10) is made integrally with the slideway (5a, 5b).

8. A module according to claim 1, wherein the slideway (5a, 5b) includes an indicator characterizing the individual stream of air that can pass through the associated housing (5).

9. A module according to claim 8, wherein the indicator is a colored strip (13).

10. A module according to claim 8, wherein the slideway (5a, 5b) is itself colored in order to form the indicator.

11. An electronics card for a module according to claim 1, including an indicator characterizing the individual stream of air that needs to pass through the housing associated with the card in order to cool said card.

12. An electronics card according to claim 11, wherein the indicator is a colored strip (14), the slideway including a colored indicator that characterizes the individual stream of air that can pass through the associated housing, the electronics card being shaped so that, once it is in place in the housing, at least a portion of the colored strip and at least a portion of the colored indicator of the slideway are visible from outside the housing.

13. An electronics card of a module according to claim 5, wherein at least one face is shaped to receive a screen (11, 12).

14. A slideway of a module according to any one of claims 1 to 4 and 6 to 10, shaped to receive a screen.
